# EUROPEAN PATENT APPLICATION

(11) **EP 3 386 280 A1**
(43) Date of publication of application: **10.10.2018**
(21) Application number: 17382185.1
(22) Date of filing: 06.04.2017
(51) Int. Cl.: H05K 3/30, H05K 3/32

(54) **ELECTRONIC ASSEMBLY AND METHOD**

(71) Applicant: Valeo Iluminacion, 23600 Martos (ES)
(72) Inventor: TEBA, Daniel, 23600 Martos (ES); GUZMAN, Alfonso-Manuel, 23600 Martos (ES)

(57) **Abstract**

This invention provides an electronic assembly (1) for receiving an electronic part (10) in an automotive lighting device. This electronic assembly (1) comprises a plastics substrate (2), an electrically insulating support element (4) and a conductive link (5). The plastics substrate (2) comprises at least one conductive track (3) directly deposited on a first face (21) of the plastics substrate (2). The electrically insulating support element (4) protrudes from the first face (21) of the plastics substrate (2). The conductive link (5) is in electrical contact with the at least one conductive track (3), is mechanically coupled with the electrically insulating support element (4) and comprises a connection portion (51) suitable for being electrically connected to the electronic part (10) of an automotive lighting device (1).

## Description

### TECHNICAL FIELD

This invention belongs to the field of automotive lighting devices, and more specifically to the field of electronic devices comprising connection between directly deposited tracks and electronic parts.

### STATE OF THE ART

Conductive tracks which are directly deposited on a plastics substrate offer several advantages, but are a little fragile. As a consequence, standard connections may cause the breakage of said conductive tracks.

A solution for connecting electronic parts in an electronic circuit which comprises directly deposited tracks is desirable.

### DESCRIPTION OF THE INVENTION

The invention provides a solution for this problem by means of an electronic assembly according to claim 1, an automotive lighting device according to claim 12 and a method according to claim 13.

Preferred embodiments of the invention are defined in dependent claims.

In an inventive aspect, the invention provides an electronic assembly for receiving an electronic part in an automotive lighting device, the electronic assembly comprising
a plastics substrate comprising at least one conductive track directly deposited on a first face of the plastics substrate;
an electrically insulating support element protruding from the first face of the plastics substrate; and
a conductive link;
wherein the conductive link
is in electrical contact with the at least one conductive track
is mechanically coupled with the electrically insulating support element; and
comprises a connection portion suitable for being electrically connected to the electronic part of an automotive lighting device.

Direct deposition of a conductive track on a plastics substrate should be construed as forming the final shape of the conductive track on the plastics substrate without the need of removing metal or for any other intermediate element, such as a mask, an electrolyte or any other chemical bath or a photosensitive film. The conductive track is just directly placed on the plastics substrate.

This electronic assembly allows the connection of an electronic part to a circuit with directly deposited conductive tracks without causing damage to the conductive tracks, and with replaceable parts which may absorb the wear damage.

In some particular embodiments, the conductive link snap fits with the electrically insulating support element.

This kind of connection provides a practical and reliable attachment between the conductive link and the support element.

In some particular embodiments, the plastics substrate is three-dimensional.

A three-dimensional plastics substrate should be construed as a plastics substrate whose surface on which the conductive track extends is not completely contained in a plane. Direct deposition is particularly appropriate for such three-dimensional surfaces, in comparison to other known techniques which normally require planar surfaces for printing a circuit board.

In some particular embodiments, the conductive link is mechanically coupled directly with the electrically insulating support element by means of a clipping connection, in such a way that the clipping connection comprises a clipping element comprised in the electrically insulating support element and a clipping slot comprised in the conductive link.

This way of coupling the conductive link with the electrically insulating support element ensures a reliable attachment and at the same time, it provides for a good way of replacing a conductive link in the event it gets damaged due to wear or any other circumstance.

In some particular embodiments, the conductive link is mechanically coupled directly with the electrically insulating support element by means of a clipping connection, in such a way that the clipping connection comprises a clipping element comprised in the conductive link and a clipping slot comprised in the electrically insulating support element.

This alternative way of arranging the clipping connection is also valid for its aim.

In some particular embodiments, the electrically insulating support element is attached to the plastics substrate.

Attaching the electrically insulating support element to the plastics substrate reinforce the robustness of this device, since the electrically insulating support element may resist any small force without being displaced.

In some particular embodiments, the electrically insulating support element forms a single piece with the plastics substrate.

This way of manufacturing the electronic assembly, which may be carried out, e.g., by moulding, saves the manufacturing of one of the pieces of the assembly, since the electrically insulating support element may be made of the same material than the plastics substrate.

In some particular embodiments, the conductive link is in electrical contact with the at least one conductive track by means of a conductive adhesive.

This way of achieving the electric contact with the conductive track is advantageous, because the electric connection is less affected by the circuit being put upside down or by being put under small forces.

In some particular embodiments, the plastics substrate is plane, the electrically insulating support element has a rectangular cross section according to a plane which is parallel to the plastics substrate, and the electrically insulating support element is manufactured by plastics injection.

Such an electrically insulating support element is easy and cheap to manufacture and provides a good support for a high variety of electronic parts which may be present in automotive lighting devices.

In some particular embodiments, the connection portion of the conductive link is housed in an inner space of the electrically insulating support element.

This arrangement, with the conductive link comprising a connection portion located inside the electrically insulating support element, allows the electronic part to fit the electrically insulating support element in a tight way, since the connection portion resists the wear due to the coupling and decoupling of the electronic part, also ensuring a good electrical contact.

In some particular embodiments, the at least one directly deposited conductive track is directly deposited by means of plasma deposition.

Directly depositing a conductive track on a plastics substrate normally supposes substantial cost savings, mainly due to the fact that a dedicated printed circuit board need not be provided. Therefore, other integral parts of the device to be controlled with the electronic assembly can be taken advantage of to play the role of substrate for the conductive track.

Plasma deposition is sometimes used to directly deposit a conductive track on a plastics substrate. This process usually comprises the step of including in the plasma flow some metal dust particles, usually copper, that are melted by the plasma flow and then deposited on the plastic part, thus creating a conductive track on said plastic part. One example of this process may be found in document US 2015/174686 A1.

In some particular embodiments, the at least one directly deposited conductive track is a cable. A bare cable is an alternative solution when a higher power is needed.

In some particular embodiments, the conductive track is three-dimensional. A three-dimensional conductive track should be construed as a conductive track whose surface is not completely contained in a plane. Direct deposition is also particularly appropriate for forming such elements.

In another inventive aspect, the invention provides an automotive lighting device comprising an electronic assembly according to the previous inventive aspect.

In another inventive aspect, the invention provides a method for assembling an automotive lighting device, the method comprising the steps of
providing plastics substrate;
directly depositing a conductive track on the plastics substrate;
providing an electrically insulating support element on the plastics substrate;
providing a conductive link in electric connection with the conductive track and mechanically coupled with the electrically insulating support element, wherein the conductive link comprises a connection portion;
connecting an electronic part to the connection portion.

This way of connecting an electronic part in an electrically insulating support element allows the connection of an electronic part to a circuit with directly deposited conductive tracks without causing damage to the conductive tracks, and with replaceable parts which may absorb the wear damage.

In some particular embodiments, the connection of the electronic part to the connection portion of the conductive link is performed by means of inserting the electronic part in an inner space of the electrically insulating support element.

This arrangement allows the electronic part to fit the electrically insulating support element in a tight way, since the connection portion resists the wear due to the coupling and decoupling of the electronic part, also ensuring a good electrical contact.

In some particular embodiments of this method, the conductive track is three-dimensional.

### BRIEF DESCRIPTION OF THE DRAWINGS

To complete the description and in order to provide for a better understanding of the invention, a set of drawings is provided. Said drawings form an integral part of the description and illustrate an embodiment of the invention, which should not be interpreted as restricting the scope of the invention, but just as an example of how the invention can be carried out. The drawings comprise the following figures:
Figure 1 shows a general perspective view of an electronic assembly according to the invention.
Figure 2 shows a side cut view of a detail of an electronic assembly according to the invention.
Figure 3 shows an electronic assembly according to the invention with an electronic part of an automotive lighting device.
Figure 4 shows a lighting device comprising an electronic assembly according to the invention.

### DETAILED DESCRIPTION OF THE INVENTION

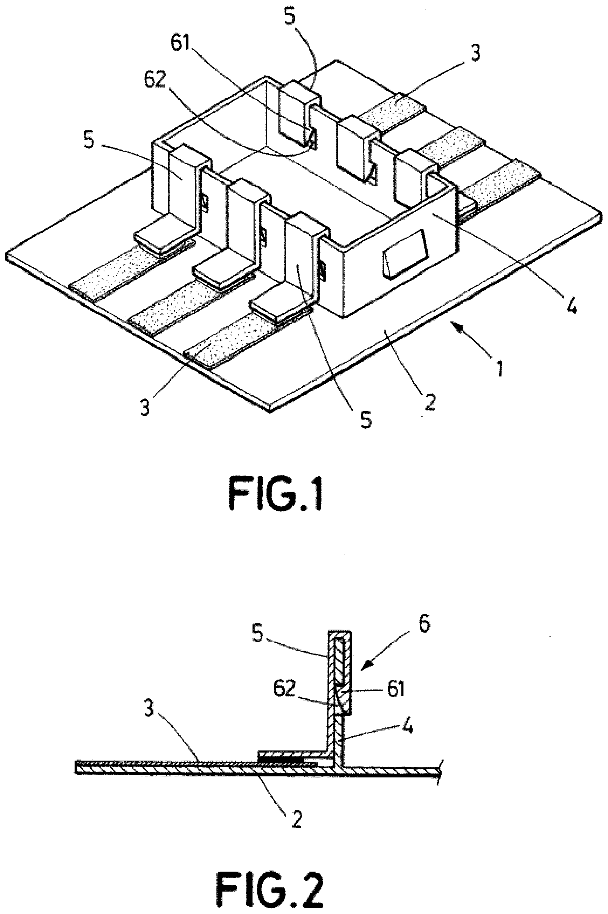

Figure 1 shows an electronic assembly 1 for receiving an electronic part 10 in an automotive lighting device, the electronic assembly 1 comprising
a plastics substrate 2 comprising a directly deposited conductive track 3;
an electrically insulating support element 4; and
a conductive link 5.

The conductive link 5 is related to the electrically insulating support element 4, the plastics substrate 2, the conductive track 3 and an electronic part 10 of the automotive lighting device in different ways.

The first relation to be analysed is the relation between the conductive link 5 and the conductive tracks 3. As may be seen in this figure, the conductive link 5 is in electrical contact with the at least one conductive track 3 by means of a conductive adhesive. This conductive adhesive is a way of keeping the electric contact between the conductive link 5 and the conductive track 3, although other ways of ensuring this electric contact are also possible in different embodiments of the invention, such as pouring a drop of a conductive material, welding or soldering.

In this embodiment, the directly deposited conductive track 3 is directly deposited by means of plasma deposition. However, in other embodiments, this conductive track may be a cable, directly deposited by a wire depositing device. Other options, such as conductive ink or conductive paste, may be used in other embodiments of the invention.

The second relation to be analysed, as shown in Figure 2, is the relation between the conductive link 5 and the electrically insulating support element 4. In the embodiment shown in this figure, the side cut view shows how the conductive link 5 is mechanically coupled directly with the electrically insulating support element 4 by means of a clipping connection 6, in such a way that the clipping connection 6 comprises a clipping element 61, which in this embodiment is comprised in the electrically insulating support element 4, and a clipping slot 62, which in this embodiment is comprised in the conductive link 5. In other embodiments, the clipping element 61 is comprised in the conductive link 5 and the clipping slot 62 is comprised in the electrically insulating support element 4. Other clipping alternatives, which would be considered by the skilled person, may also be applied for this purpose.

The conductive link 5 is therefore mechanically fixed to the electrically insulating support element 4, which serves as a positioning part for the conductive link 5 and for further elements of this arrangement. The way of fixing the conductive link 5 to the electrically insulating support element 4 is not limited to the field of clip connections. These clip connections are an easy way of releasably fixing two elements, but other ways of fixing these two elements, either permanent or not, are foreseen in this invention.

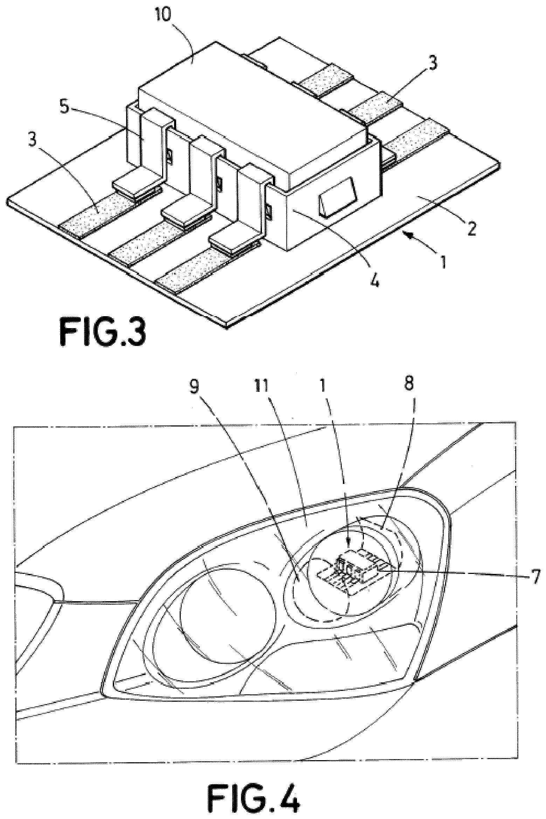

Another relation to be analysed is the relation between the conductive link 5 and an electronic part 10 of the lighting device, as shown in Figure 3. The electrically insulating support element 4 has a shape which enables an electronic part 10 of the lighting device to be positioned with respect to the electronic assembly 1. To make this positioning easier, the plastics substrate 2 is plane and the electrically insulating support element 4 has a rectangular cross section according to a plane which is parallel to the plastics substrate 2. Further, the electrically insulating support element 4 may be manufactured by plastics injection. In this particular embodiment, the connection portion 51 of the conductive link 5 is housed in an inner space of the electrically insulating support element 4. This location makes it easier for the conductive link 5 to make contact with the electronic part 10.

The conductive link 5 comprises a connection portion 51 suitable for being electrically connected to this electronic part 10. As the conductive link 5 is mechanically fixed to the electrically insulating support element 4, the electrically insulating support element 4 may be designed to house the electronic part 10 in such a way that an electric contact may be achieved between the connection portion 51 of the conductive link 5 and this electronic part 10. The electrically insulating support element 4 may be attached to the plastics substrate 2, to ensure a better positioning between all the elements comprising the electronic circuit.

Figure 4 shows an automotive lighting device comprising
an electronic assembly 1 according to the invention;
a semiconductor light source 7 in electric connection with the electronic assembly 1;
a reflector 8, and a projection lens 9, suitable for receiving light from the semiconductor light source 7 and projecting it in the shape of a light pattern in a forward direction; and
a housing 11 accommodating the electronic assembly 1, the semiconductor light source 7, the reflector 8 and the projection lens 9.

In the particular embodiment shown in this figure, the optical elements include a reflector 8 and a projection lens 9. The reflector 8 is placed in the electronic assembly 1, arranged to reflect the light emitted by the semiconductor light source 7. The projection lens is in turn located in a forward position with respect to the automotive lighting device, and receives the light from the light source 7 which has been reflected by the reflector 8. The projection lens 9 orientates this received light according to the vehicle advancing direction.

These optical elements 8, 9 makes the lighting device suitable for being installed in an automotive vehicle and able to perform lighting functions, such as high-beam and low-beam.

## Claims

1. Electronic assembly (1) for receiving an electronic part (10) in an automotive lighting device, the electronic assembly (1) comprising
a plastics substrate (2) comprising at least one conductive track (3) directly deposited on a first face (21) of the plastics substrate (2);
an electrically insulating support element (4) protruding from the first face (21) of the plastics substrate (2); and
a conductive link (5);
wherein the conductive link (5)
is in electrical contact with the at least one conductive track (3);
is mechanically coupled with the electrically insulating support element (4); and
comprises a connection portion (51) suitable for being electrically connected to the electronic part (10).

2. Electronic assembly (1) according to claim 1, wherein the conductive link (5) snap fits with the electrically insulating support element (4).

3. Electronic assembly (1) according to claim 2, wherein the conductive link (5) is mechanically coupled directly with the electrically insulating support element (4) by means of a clipping connection (6), in such a way that the clipping connection (6) comprises a clipping element (61) comprised in the electrically insulating support element (4) and a clipping slot (62) comprised in the conductive link (5).

4. Electronic assembly (1) according to claim 2, wherein the conductive link is mechanically coupled directly with the electrically insulating support element (4) by means of a clipping connection (6), in such a way that the clipping connection (6) comprises a clipping element (61) comprised in the conductive link (5) and a clipping slot (62) comprised in the electrically insulating support element (4).

5. Electronic assembly (1) according to any of the preceding claims, wherein the electrically insulating support element (4) is attached to the plastics substrate (2).

6. Electronic assembly (1) according to any of claims 1 to 4, wherein the electrically insulating support element (4) forms a single piece with the plastics substrate (2).

7. Electronic assembly (1) according to any of the preceding claims, wherein the conductive link (5) is in electrical contact with the at least one conductive track (3) by means of a conductive adhesive.

8. Electronic assembly (1) according to any of the preceding claims, wherein the plastics substrate (2) is plane, the electrically insulating support element (4) has a rectangular cross section according to a plane which is parallel to the plastics substrate (2), and the electrically insulating support element (4) is manufactured by plastics injection.

9. Electronic assembly (1) according to any of the preceding claims, wherein the connection portion (51) of the conductive link (5) is housed in an inner space of the electrically insulating support element (4).

10. Electronic assembly (1) according to any of the preceding claims, wherein the at least one directly deposited conductive track (3) is directly deposited by means of plasma deposition.

11. Electronic assembly (1) according to any of the preceding claims, wherein the at least one directly deposited conductive track (3) is a cable.

12. Electronic assembly (1) according to any of the preceding claims, wherein the conductive track (3) is three-dimensional.

13. Automotive lighting device comprising an electronic assembly (1) according to any of the preceding claims.

14. Method for assembling an automotive lighting device, the method comprising the steps of
providing a plastics substrate (2);
directly depositing a conductive track (3) on the plastics substrate (2);
providing an electrically insulating support element (4) on the plastics substrate (2);
providing a conductive link (5) in electric connection with the conductive track (3) and mechanically coupled with the electrically insulating support element (4), wherein the conductive link (5) comprises a connection portion (51);
connecting an electronic part to the connection portion (51).

15. Method according to claim 14, wherein the connection of the electronic part to the connection portion (51) of the conductive link (5) is performed by means of inserting the electronic part (10) in an inner space of the electrically insulating support element (4).

## Amended claims

### Amended claims in accordance with Rule 137(2) EPC.

1. Electronic assembly (1) for receiving an electronic part (10) in an automotive lighting device, the electronic assembly (1) comprising
a plastics substrate (2) comprising at least one conductive track (3) directly deposited on a first face (21) of the plastics substrate (2);
an electrically insulating support element (4) protruding from the first face (21) of the plastics substrate (2); and
a conductive link (5);
wherein the conductive link (5)
is in electrical contact with the at least one conductive track (3);
is mechanically coupled with the electrically insulating support element (4); and
comprises a connection portion (51) suitable for being electrically connected to the electronic part (10), the electronic assembly (1) being **characterized in that**, wherein the conductive link (5) is mechanically coupled directly with the electrically insulating support element (4) by means of a clipping connection (6), in such a way that
the clipping connection (6) comprises a clipping element (61) comprised in the electrically insulating support element (4) and a clipping slot (62) comprised in the conductive link (5); or
the clipping connection (6) comprises a clipping element (61) comprised in the conductive link (5) and a clipping slot (62) comprised in the electrically insulating support element (4).

2. Electronic assembly (1) according to claim 1, wherein the conductive link (5) snap fits with the electrically insulating support element (4).

3. Electronic assembly (1) according to any of the preceding claims, wherein the electrically insulating support element (4) is attached to the plastics substrate (2).

4. Electronic assembly (1) according to any of claims 1 to 2, wherein the electrically insulating support element (4) forms a single piece with the plastics substrate (2).

5. Electronic assembly (1) according to any of the preceding claims, wherein the conductive link (5) is in electrical contact with the at least one conductive track (3) by means of a conductive adhesive.

6. Electronic assembly (1) according to any of the preceding claims, wherein the plastics substrate (2) is plane, the electrically insulating support element (4) has a rectangular cross section according to a plane which is parallel to the plastics substrate (2), and the electrically insulating support element (4) is manufactured by plastics injection.

7. Electronic assembly (1) according to any of the preceding claims, wherein the connection portion (51) of the conductive link (5) is housed in an inner space of the electrically insulating support element (4).

8. Electronic assembly (1) according to any of the preceding claims, wherein the at least one directly deposited conductive track (3) is directly deposited by means of plasma deposition.

9. Electronic assembly (1) according to any of the preceding claims, wherein the at least one directly deposited conductive track (3) is a cable.

10. Electronic assembly (1) according to any of the preceding claims, wherein the conductive track (3) is three-dimensional.

11. Automotive lighting device comprising an electronic assembly (1) according to any of the preceding claims.

12. Method for assembling an automotive lighting device, the method comprising the steps of
providing a plastics substrate (2);
directly depositing a conductive track (3) on the plastics substrate (2);
providing an electrically insulating support element (4) on the plastics substrate (2);
providing a conductive link (5) in electric connection with the conductive track (3) and mechanically coupled with the electrically insulating support element (4) by means of a clipping connection (6), in such a way that
the clipping connection (6) comprises a clipping element (61) comprised in the electrically insulating support element (4) and a clipping slot (62) comprised in the conductive link (5); or
the clipping connection (6) comprises a clipping element (61) comprised in the conductive link (5) and a clipping slot (62) comprised in the electrically insulating support element (4);
wherein the conductive link (5) comprises a connection portion (51)connecting an electronic part to the connection portion (51).

13. Method according to claim 12, wherein the connection of the electronic part to the connection portion (51) of the conductive link (5) is performed by means of inserting the electronic part (10) in an inner space of the electrically insulating support element (4).
